# EUROPEAN PATENT APPLICATION

(11) **EP 4 769 887 A1**
(43) Date of publication of application: **01.07.2026**
(21) Application number: 25861217.5
(22) Date of filing: 08.08.2025
(51) Int. Cl.: H02J 7/00, H02J 7/34, G01R 31/3842, G01R 31/389, H01M 10/44, H01M 10/42

(54) **DEVICE AND METHOD FOR CONTROLLING BATTERY**

(30) Priority: 02.09.2024 KR 20240118296
(71) Applicant: LG Energy Solution, Ltd., Seoul 07335 (KR)
(72) Inventor: SUNG, Chang Hyun, Daejeon 34122 (KR); KANG, Juyoung, Daejeon 34122 (KR); MUN, Byoung Jun, Daejeon 34122 (KR); PARK, Hyeonghun, Daejeon 34122 (KR)
(74) Representative: Goddar, Heinz J.
(86) International application number: PCT/KR2025/012053
(87) International publication number: WO 2026/049355

(57) **Abstract**

A device for controlling a battery, according to an embodiment of the present invention, controls a battery pack including a plurality of modules, each module including a plurality of cells connected in series, and may include: a selection circuit unit including one or more switches connected to a positive electrode of each cell and one or more switches connected to a negative electrode of each cell; a resonance circuit unit including one or more inductors and one or more capacitors and having one end connected to a first node and the other end connected to a second node; and a control unit that controls the plurality of switches in the selection circuit unit and one or more switches in the resonance circuit unit to measure the impedance of a selected cell among the plurality of cells or to perform charge equalization between the plurality of cells or charge equalization between the plurality of modules.

## Description

### [Technical Field]

This application claims priority to and the benefit of Korean Patent Application No.10-2024-0118296 filed in the Korean Intellectual Property Office on September 2, 2024 the entire contents of which are incorporated herein by reference.

The present invention relates to a battery control apparatus and method, and more particularly, to a battery control apparatus and method including a circuit capable of both charge equalization and battery impedance measurement.

### [Background Art]

Secondary batteries, capable of recharging and reuse, are manufactured as battery modules or battery packs by connecting a plurality of battery cells in series based on the required output capacity, serving as power sources for diverse applications. These batteries are used in small, high-tech electronic devices like smart phones, as well as a variety of fields including electric bicycles, electric vehicles, and energy storage systems (ESS).

A battery pack is a structure composed of a plurality of battery cells. Overvoltage, overcurrent, and overheating in some battery cells may compromise the safety and operational efficiency of the battery pack, making detection of these defects essential. Thus, battery packs are usually equipped with a battery management system (BMS) that measures the voltage of each battery cell and monitors and controls the voltage state of the cells based on these measurements.

Meanwhile, the performance of the plurality of battery cells within a battery pack may vary for various reasons, resulting in voltage imbalances among cells. If a battery pack is used with a voltage imbalance among cells, its performance becomes dependent on degraded cells, limiting the overall performance of the battery pack. In other words, the cell imbalance reduces the available capacity/power of the battery.

Furthermore, degraded battery cells tend to deteriorate further, accelerating cell aging. If these degraded cells are left unattended, the lifespan of the battery pack will be rapidly reduced.

To address this cell imbalance issue, passive balancing, which selectively connects resistors across the battery cell terminals to discharge the cells, or active balancing, which transfers power from high-voltage cells to low-voltage cells via capacitors, is generally used.

Meanwhile, a method of measuring and analyzing battery impedance is a frequently used for assessing battery deterioration or abnormalities. To measure battery impedance, a circuit for measuring the impedance of each cell is typically added, to acquire the necessary measurements and calculate the impedance by using these measurements.

As such, equalization designed to address cell imbalance and impedance measurement were previously performed using separate devices or circuits.

Among the prior art documents relevant to the present invention, KR 10-2016-0064089 A is of some relevance.

### [Detailed Description of the Invention]

### [Technical Problem]

To obviate one or more problems of the related art, embodiments of the present disclosure provide a battery control apparatus including a control circuit capable of performing both inter-cell/module **balancing** and battery impedance measurement.

To obviate one or more problems of the related art, embodiments of the present disclosure also provide a battery pack including the battery control apparatus.

### [Technical Solution]

In order to achieve the objective of the present disclosure, an apparatus, for controlling a battery pack including a plurality of modules, each module including a plurality of cells connected in series, may include a selection circuit comprising one or more switches connected to the positive electrode of each cell and one or more switches connected to the negative electrode of each cell; a resonant circuit including one or more inductors and one or more capacitors, one end of the resonant circuit connected to a first node and the other end of the resonant circuit connected to a second node; and a controller configured to control a plurality of switches in the selection circuit and one or more switches in the resonant circuit to measure impedance for a selected cell among the plurality of cells or to perform charge equalization among the plurality of cells or among the plurality of modules.

The resonant circuit may include a first inductor; and a first capacitor connected in series with the first inductor.

The resonant circuit may further include a second inductor and an inductor connection switch which are connected in parallel with the first inductor; and a second capacitor and a capacitor connection switch which are connected in parallel with the first capacitor.

Here, a resonant frequency provided by the resonant circuit may vary depending on ON/OFF of the inductor connection switch and the capacitor connection switch.

Furthermore, the battery control apparatus may further include a voltage meter measuring a voltage between the first node and the second node; and a current meter measuring a current flowing through the resonant circuit.

Here, the controller may be further configured to: turn on a switch connected to the positive electrode of a cell to be impedance measured and a switch connected to the negative electrode of the cell; and calculate the impedance of the cell based on a voltage obtained from the voltage meter and a current obtained from the current meter.

In addition, the battery control apparatus may further include a polarity reversing switch having one end connected to the first node and the other end connected to the second node.

Meanwhile, the controller may be further configured to: turn on the positive connection switch and the negative connection switch of the first cell, thereby accumulating energy in the capacitor within the resonant circuit; and subsequently, turn off the positive connection switch and the negative connection switch of the first cell and turn on the positive connection switch and the negative connection switch of the second cell, so that energy from the first cell is transferred to the second cell.

Here, the controller may be further configured to: if the first cell and the second cell are, in terms of the serial connection structure of the cells, one is an odd cell and the other is an even cell, before controlling turning on of the positive connection switch and the negative connection switch of the second cell, turn on the polarity reversing switch to reverse the polarity of the capacitor within the resonant circuit; and subsequently, turn on the positive connection switch and the negative connection switch of the second cell, thereby transferring energy stored in the capacitor to the second cell.

In addition, the controller may be further configured to: if the first cell and the second cell are, in terms of the serial connection structure of the cells, both are odd cells or both are even cells, after transferring energy stored in the capacitor to the second cell, turn on the polarity reversing switch to reverse the polarity of the capacitor within the resonant circuit.

Here, the controller may control the inductor connection switch and the capacitor connection switch to be turned off when performing cell-to-cell charge equalization from a first cell to a second cell.

Meanwhile, the resonant circuit may include an inductor connected to the first node; and a capacitor connected to the second node, and the resonant circuit may be arranged in each module.

The apparatus may further include one or more resonant circuit connection switch units connecting resonant circuits located within each module, and each resonant circuit connection switch unit may include a pair of resonant circuit connection switches connected to one end and the other end of a capacitor of a resonant circuit within each module.

The controller may be configured to perform charge equalization between a first module and a second module by: turning on a switch connected to the positive electrode of a first cell among the series-connected cells in the first module and a switch connected to the negative electrode of a last cell among the series-connected cells and turning on the one or more resonant circuit connection switch units within the battery pack, thereby accumulating energy in capacitors within a plurality of resonant circuits; and subsequently, turning off connection switches of the first module and turning on a switch connected to the positive electrode of a first cell among the series-connected cells in the second module and a switch connected to the negative electrode of a last cell among the series-connected cells in the second module.

Furthermore, the controller may be configured to turn on a switch connected to the positive electrode and a switch connected to the negative electrode of a cell to be impedance measured; measure a current flowing through the resonant circuit and a voltage between the first node and the second node; and calculate the impedance of the target cell based on the measured current and voltage.

Here, a resonant frequency of the resonant circuit varies depending on ON/OFF state of the one or more resonant circuit connection switch units.

According to another embodiment of the present disclosure, a battery pack comprising a plurality of modules may include a plurality of cells connected in series; a selection circuit including one or more switches connected to the positive electrode of each cell and one or more switches connected to the negative electrode of each cell; and a resonant circuit including one or more inductors and one or more capacitors, one end of the resonant circuit connected to a first node and the other end of the resonant circuit connected to a second node, and the battery pack may include a controller configured to control a plurality of switches in the selection circuit and one or more switches in the resonant circuit to measure impedance for a selected cell among the plurality of cells or to perform charge equalization among the plurality of cells or charge equalization among the plurality of modules.

### [Advantageous Effects]

A battery control apparatus according to one embodiment of the present disclosure makes both charge equalization among cells and battery impedance measurement possible.

A battery control apparatus according to another embodiment of the present disclosure makes both charge equalization among modules and battery impedance measurement possible.

In addition, impedance can be measured in various resonant frequency environments, thereby providing more accurate battery diagnosis.

### [Brief Description of the Drawings]

FIG. 1 illustrates an example of a battery structure to which embodiments of the present invention can be applied.
FIG. 2 illustrates a circuit diagram of a battery control apparatus according to an embodiment of the present invention.
FIG. 3 illustrates a current flowing in a resonant circuit according to embodiments of the present invention.
FIG. 4 is a diagram exemplarily illustrating a path formed between a selected cell and the resonant circuit when measuring impedance using a battery control apparatus according to embodiments of the present invention.
FIG. 5 illustrates a first example of an operation sequence for performing cell-to-cell balancing using a battery control apparatus according to embodiments of the present invention.
FIG. 6 illustrates a second example of cell-to-cell balancing using a battery control apparatus according to embodiments of the present invention.
FIG. 7 illustrates a circuit diagram of a battery control apparatus according to another embodiment of the present invention.
FIGS. 8a and 8b illustrate exemplary operational sequences for performing intermodule balancing using a battery control apparatus according to embodiments of the present invention.

100: battery pack
200: BMS
210: controller
220, 720: selection circuit
230, 730: resonant circuit
770: resonant circuit connection switch units

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module may include a plurality of battery cells connected in series.

A battery pack is an assembly of a plurality of battery cells electrically connected and may be configured with a plurality of modules connected in series or parallel.

Hereinafter, exemplary embodiments of the present invention will be described in detail with reference to the accompanying drawings.

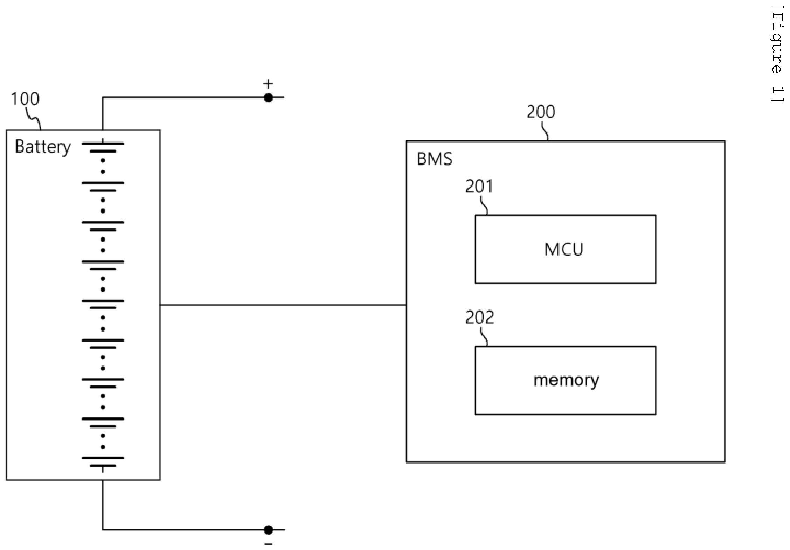

FIG. 1 illustrates an example of a battery structure to which embodiments of the present invention can be applied.

In FIG. 1, a battery pack 100 may include a plurality of battery cells. A plurality of battery cells may be connected in series to form modules and a battery pack may include a plurality of modules. The most commonly used battery cells are lithium-ion (Li-Ion) battery cells. The battery pack may be connected to a load through positive and negative terminals and perform charge/discharge operations. Each battery pack may be equipped with a battery management system (BMS).

The BMS 200 may monitor the current, voltage, and temperature of each battery pack to be managed, calculate state of charge (SOC) based on monitoring results, and control charging and discharging. Here, the SOC represents the current charge level of the battery as a percentage (%).

To perform these operations, the BMS 200 may include various components, such as a fuse, a current sensing element, a thermistor, a switch, and a balancer. The BMS 200 typically includes a micro controller unit (MCU) 201 or a Battery Monitoring Integrated Chip (BMIC) for interfacing with and controlling these components. The BMIC may be an IC-type component located within the BMS and capable of measuring information such as voltage, temperature, and current of battery cells/modules. The BMS 200 may also include a memory 202 that stores at least one command executed by the MCU and various data generated during BMS operation.

In addition, the BMS may monitor battery cells, reads cell voltages, and transmit them to other systems connected to the battery. For this, the BMS may include a communication module (not shown) for communicating with other systems within a device including the battery system. The BMS communication module may communicate with other systems within the device using a Controller Area Network (CAN). Here, components, modules, or systems within the BMS may be interconnected via the CAN bus.

The battery control apparatus according to embodiments of the present invention, described below, may be incorporated into a pack BMS and implemented as part of the pack BMS.

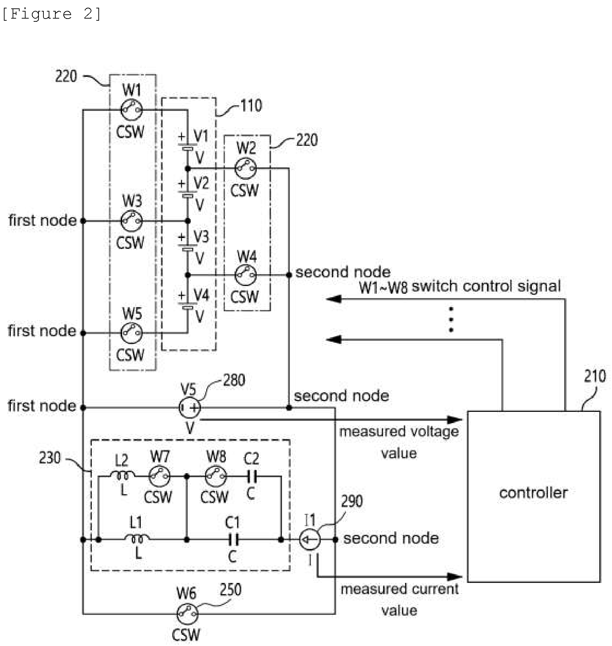

FIG. 2 illustrates a circuit diagram of a battery control apparatus according to an embodiment of the present invention.

The battery control apparatus according to embodiments of the present invention can be applied to a battery structure in which a battery pack includes a plurality of modules, each of which has a plurality of cells electrically connected in series. For example, as illustrated in FIG. 2, module 110 may have a plurality of cells connected in series.

The battery control apparatus according to embodiments of the present invention may control a battery pack including a plurality of modules, each of which includes a plurality of cells connected in series. The battery control apparatus may be configured to include a controller 210, a selection circuit 220, and a resonant circuit 230. The controller 210 may control a plurality of switches within the selection circuit and one or more switches within the resonant circuit to measure the impedance of one of the a plurality of cells or perform charge equalization among the plurality of cells or among the plurality of modules.

The embodiment described in FIG. 2 specifically describes a battery control apparatus that measures the impedance of one of a plurality of cells or performs cell balancing among the plurality of cells.

More specifically, in FIG. 2, the controller 210 may generate switch control signals for switches W1, W2, W3, W4, and W5 within the selection circuit 220 and switches W7 and W8 within the resonant circuit 230, and transmit the switch control signals to corresponding circuits. Furthermore, the controller 210 may receive a voltage value measured by a voltage meter 280 and a current value measured by a current meter 290 to calculate an impedance value for the selected cell.

Furthermore, the selection circuit 220 may include one or more switches connected to the positive electrode of each cell and one or more switches connected to the negative electrode of each cell. For example, in FIG. 2, the selection circuit 220 may include five switches W1, W2, W3, W4, W5 connected to the positive and negative electrodes of four cells. The positive electrode of the first cell is connected to the first switch and the negative electrode of the first cell is connected to the second switch. The second switch is also connected to the positive electrode of the second cell. The negative electrode of the second cell is connected to the third switch and the third switch is simultaneously connected to the positive electrode of the third cell. In summary, the switches connected to the positive electrodes of the plurality of cells connected in series are connected to the first node or the second node in an alternating manner. In other words, the first switch connected to the positive electrode of the first cell and the third switch connected to the positive electrode of the third cell have one end connected to the first node, and the second switch connected to the positive electrode of the second cell and the fourth switch connected to the positive electrode of the fourth cell have one end connected to the second node. In other words, the switches connected to the negative electrodes of the plurality of cells connected in series can be described as being connected to the second node or the first node in an alternating manner.

Meanwhile, switches W1, W2, W3, W4, W5 included in the selection circuit 220 may be implemented with various switching elements, and according to one embodiment, the switches may be implemented with Metal Oxide Semiconductor Field Effect Transistors (MOSFETs). The switches W1, W2, W3, W4, W5 may be selectively turned on or off according to a control signal from the controller 210.

In addition, the resonant circuit 230 may have a form in which one or more inductors and one or more capacitors are connected in series through one or more switches, and one end of the resonant circuit 230 is connected to a first node and the other end of the resonant circuit 230 is connected to a second node.

Here, the resonant circuit may include: a first inductor; a first capacitor connected in series with the first inductor; a second inductor and an inductor connection switch which are connected in parallel with the first inductor; a second capacitor and a capacitor connection switch which are connected in parallel with the first capacitor.

More specifically, referring to FIG. 2, the resonant circuit 230 may include an inductance section (L1, L2) and a capacitance section (C1, C2), which are connected in series.

The inductance section (L1, L2) may be formed with a first inductor (L1) and a second inductor (L2) connected in parallel. The second inductor (L2) may form part of the inductance section together with first inductor L1 by turning on inductor connection switch W7. In contrast, when inductor connection switch W7 is turned off, second inductor L2 is excluded from the inductance section. In other words, the inductance value of the inductance section may be adjusted according to the on/off control of the inductor connection switch.

The capacitance section (C1, C2) may be configured with a first capacitor C1 and a second capacitor C2 connected in parallel. The second capacitor C2 may form part of the capacitance section together with the first capacitor C1 by turning on the capacitor connection switch W8. In contrast, when the capacitor connection switch W8 is turned off, the second capacitor C2 may be excluded from the capacitance section. In other words, the capacitance value of the capacitance section may be adjusted according to the on/off control of the capacitor connection switch.

In other words, the resonant frequency provided by the resonant circuit 230 may vary depending on the on/off states of the inductor connection switch W7 and the capacitor connection switch W8.

Meanwhile, the battery control apparatus according to embodiments of the present embodiment may further include a voltage meter 280 for measuring the voltage between the first node and the second node, and a current meter 290 for measuring the current flowing through the resonant circuit. The controller may turn on a switch connected to the positive electrode of the cell to be impedance measured and a switch connected to the negative electrode of the cell, and calculate the impedance of the corresponding cell based on the voltage obtained from the voltage meter and the current obtained from the current meter.

In addition, when a battery pack is configured by including a plurality of modules as illustrated in FIG. 2, the controller 210 according to the embodiment of FIG. 2 may be implemented by being placed in each module. Furthermore, the battery pack may be also implemented in a manner in which only one controller 210 is placed in the battery pack to control the circuitry within each module.

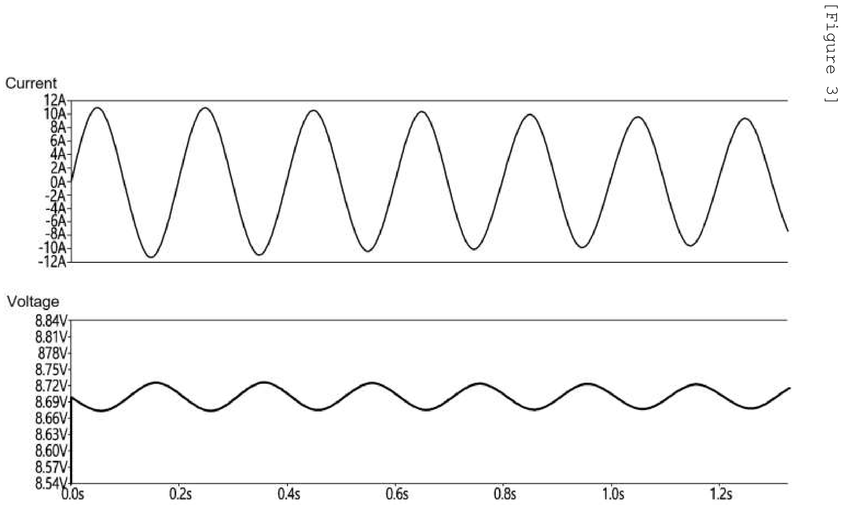

FIG. 3 illustrates the current flowing in a resonant circuit and the cell voltage according to embodiments of the present invention.

The upper graph in FIG. 3 represents the resonant current flowing in the resonant circuit 230 of FIG. 2. The resonant current is an alternating current (AC) flowing through a path connecting a cell selected by the controller, a first inductor, and a first capacitor. In other words, the resonant current may be a current flowing through the selected cell.

Furthermore, the lower graph in FIG. 3 represents the measured voltage between the first node and the second node in the circuit of FIG. 2. If a cell is selected by the control of a switch in the selection circuit, either the first or second node may be connected to the positive electrode of the cell, and the other node may be connected to the negative electrode of the cell. Thus, the voltage between the first and second nodes is equal to the voltage of the corresponding cell.

Therefore, the controller may calculate the impedance of the selected cell from the magnitude and phase difference of AC components of the measured current and voltage.

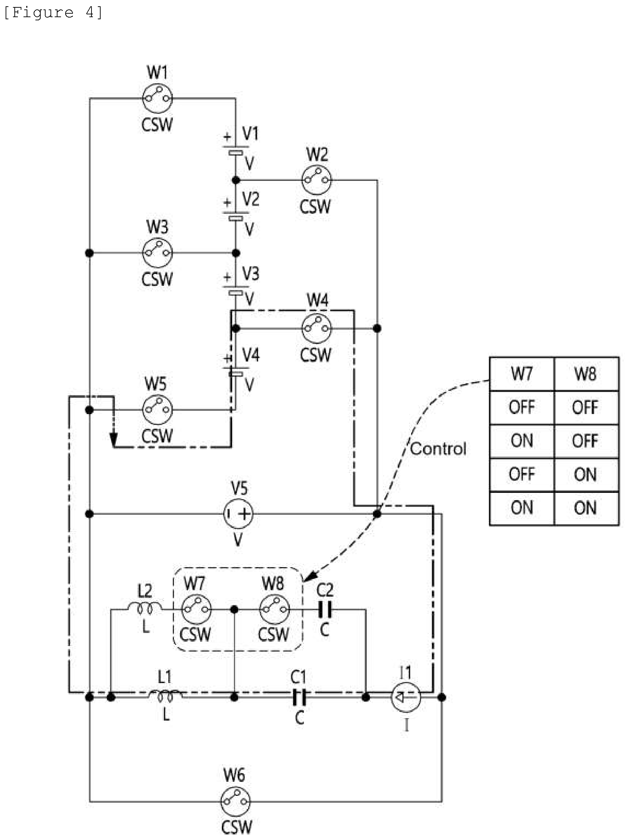

FIG. 4 is a diagram exemplarily illustrating a path formed between a selected cell and the resonant circuit when measuring impedance using a battery control apparatus according to embodiments of the present invention.

FIG. 4 illustrates an electrical flow generated when the fourth switch (W4) and the fifth switch (W5) are turned on to measure the impedance of the fourth cell among four cells in a module. If both the inductor connection switch W7 and the capacitor connection switch W8 within the resonant circuit are turned off, the current flow is as illustrated in FIG. 4.

Meanwhile, the resonant frequency provided by the resonant circuit 230 varies depending on the ON/OFF status of the inductor connection switch W7 and the capacitor connection switch W8. As illustrated in FIG. 4, there are four possible ON/OFF scenarios for the inductor connection switch W7 and the capacitor connection switch W8. Thus, the resonant circuit according to the embodiment of FIG. 4 may provide a total of four resonant frequencies. Therefore, the controller may adjust the resonant frequency by changing the connection status of the inductor connection switch W7 and the capacitor connection switch W8, and may measure the impedance at different frequencies.

Returning back to FIG. 2, the controller 210 may control a plurality of switches within the selection circuit and one or more switches within the resonant circuit to perform charge balancing among a plurality of cells. For this, the battery control apparatus according to embodiments of the present invention may further include a polarity reversing switch 250 having one end connected to the first node and the other end connected to the second node. Here, the polarity reversing switch 250 is a switch for changing the polarity of the resonant capacitor C1.

More specifically, the controller may turn on the positive and negative connection switches of the first cell to accumulate energy in the capacitor within the resonant circuit. Then, the controller may turn off the positive and negative connection switches of the first cell and turn on the positive and negative connection switches of the second cell, thereby performing charge balancing between the first cell and the second cell.

According to one embodiment, when the first cell and the second cell are, in terms of the order of the cell connection structure, one is an odd cell and the other is an even cell, before controlling the turning on of the positive connection switch and the negative connection switch of the second cell, the polarity reversing switch is turned on to invert the polarity of the capacitor within the resonant circuit, and then the positive connection switch and the negative connection switch of the second cell are turned on to control the turning on of the energy stored in the capacitor, so that the energy stored in the capacitor can be transferred to the second cell.

According to another embodiment, when the first cell and the second cell are, in terms of the order of the cell connection structure, both cells are odd cells or both cells are even cells, after the energy stored in the capacitor is transferred to the second cell, the polarity reversing switch may be turned on to invert the polarity of the capacitor within the resonant circuit.

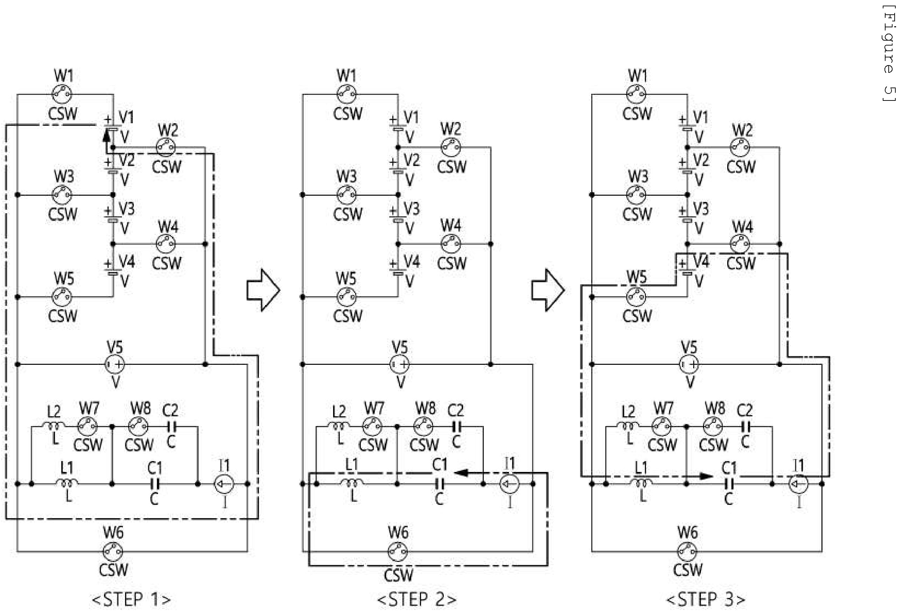

FIG. 5 illustrates a first example of an operation sequence for performing cell-to-cell balancing using a battery control apparatus according to embodiments of the present invention.

The example of FIG. 5 illustrates a sequence of cell-to-cell balancing operation when energy is transferred from a first cell to a fourth cell.

More specifically, the controller turns on the positive and negative connection switches of the first cell to accumulate energy in a capacitor C1 within the resonant circuit (step 1 of FIG. 5). Then, the controller turns off the positive and negative connection switches of the first cell and turns on the positive and negative connection switches of the fourth cell (step 3 of FIG. 5), thereby performing cell-to-cell balancing from the first cell to the fourth cell.

Here, since the first cell is an odd cell and the fourth cell is an even cell in the order of the serial connection structure of the cells, before controlling the turning on of the positive connection switch and the negative connection switch of the fourth cell, the polarity reversing switch (W6) is turned on to invert the polarity of the capacitor C1 in the resonant circuit (step 2 in FIG. 5), and then the positive connection switch and the negative connection switch of the fourth cell are controlled to be turned on, so that the energy stored in the capacitor can be transferred to the fourth cell (step 3 in FIG. 5). Here, when energy is accumulated in the capacitor C1 in the resonant circuit, the voltage of the first node becomes higher than that of the second node, and in order to transfer energy to the fourth cell, the voltage of the second node must be higher than that of the first node. Therefore, the polarity of the resonant capacitor is controlled to be inverted through the polarity reversing switch before transferring energy to the fourth cell.

Thereafter, the controller may repeat steps 1 to 3 described above. The number of repetitions may be determined based on factors such as the voltage difference between cells that requires energy transfer and the accumulable capacity of the resonant capacitor.

Meanwhile, while inter-cell balancing is performed, the controller may control the inductor connection switch W7 and capacitor connection switch W8 within the resonant circuit to be turned ON or OFF. Depending on the ON/OFF states of the inductor connection switch W7 and capacitor connection switch W8, the impedance of the resonant circuit may be changed, thereby controlling the balancing current. While increasing the balancing current has the advantage of faster balancing, it also has the disadvantage of increasing the energy consumed by the circuit. Therefore, the impedance can be appropriately adjusted by controlling the inductor connection switch and capacitor connection switch depending on the situation.

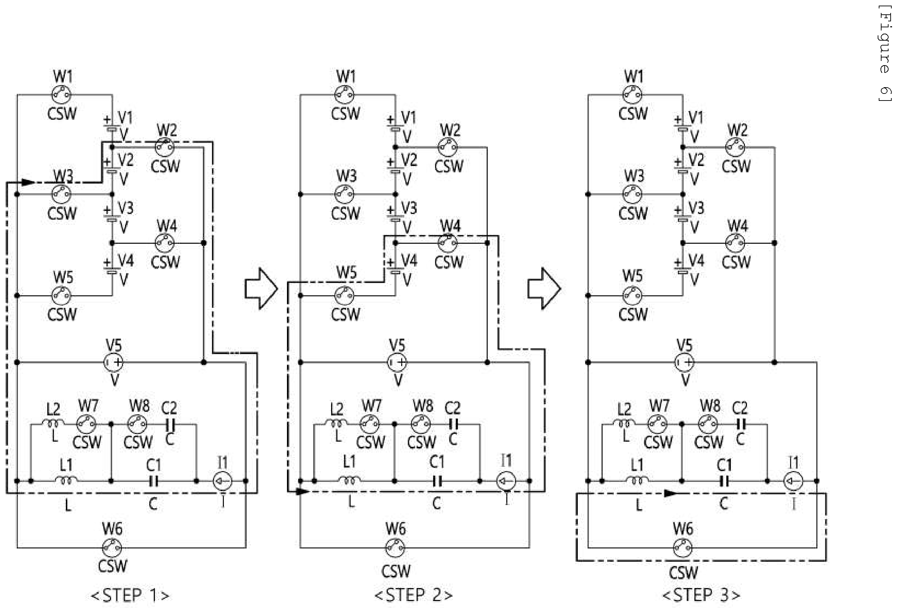

FIG. 6 illustrates a second example of cell-to-cell balancing using a battery control apparatus according to embodiments of the present invention.

The example of FIG. 6 illustrates the cell-to-cell balancing operation sequence when energy is transferred from a second cell to a fourth cell.

More specifically, the controller may turn on the positive and negative connection switches of the second cell to accumulate energy in a capacitor within the resonant circuit (step 1 of FIG. 6). Afterwards, the controller may turn off the positive and negative connection switches of the second cell and turn on the positive and negative connection switches of the fourth cell (step 2 of FIG. 6), which allows charge equalization between the second and fourth cells.

In addition, since the second cell and the fourth cell are both even cells in terms of the order of the serial connection structure of the cells, after transferring the energy stored in the capacitor C1 to the fourth cell, the polarity reversing switch (W6) is turned on (step 3 of FIG. 6) to reverse the polarity of the capacitor C1 in the resonant circuit. In this embodiment, the procedure of reversing the polarity of the resonant capacitor through the polarity reversing switch is to more efficiently transfer energy through reversing the polarity of the resonant capacitor that accumulates energy. More specifically, the size of the resonant current is proportional to the difference between the cell voltage and the initial voltage of the resonant capacitor. If charging and discharging are repeated in the same direction, the voltage of the resonant capacitor converges to the same level as the cell voltage, which causes a problem in which the size of the resonant current continues to decrease. In this embodiment, this problem can be solved by turning on the polarity reversing switch to reverse the polarity of the resonant capacitor.

Thereafter, the controller may repeatedly perform steps 1 to 3 described above. The number of repetitions may be determined based on factors such as the voltage difference between cells that requires energy transfer and the accumulable capacity of the resonant capacitor, etc.

Meanwhile, while the inter-cell balancing is performed, the controller may control the inductor connection switch W7 and the capacitor connection switch W8 within the resonant circuit to be turned ON or OFF. The impedance of the resonant circuit may be changed depending on the ON/OFF states of the inductor connection switch W7 and the capacitor connection switch W8, thereby controlling the balancing current. While increasing the balancing current has the advantage of achieving balancing faster, it also has the disadvantage of increasing the energy consumed in the circuit. Therefore, the impedance can be appropriately adjusted and used by controlling the inductor connection switch and the capacitor connection switch depending on the situation.

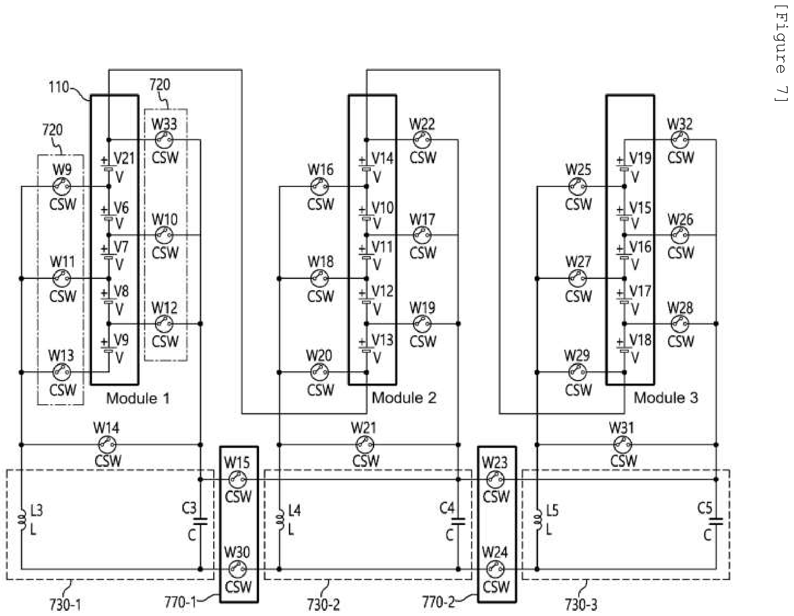

FIG. 7 illustrates a circuit diagram of a battery control apparatus according to another embodiment of the present invention.

The battery control apparatus according to embodiments of the present invention may be applied to a battery structure in which a battery pack includes a plurality of modules and a plurality of cells are electrically connected in series within a single module. Here, a plurality of modules (module 1, module 2, and module 3) within the same pack may be implemented in a series-connected configuration, as illustrated in FIG. 7.

The battery control apparatus according to embodiments of the present invention may control a battery pack including a module 110 including a plurality of cells connected in series. The battery control apparatus may be configured to include a controller (not shown), a selection circuit 720, and a resonant circuit 730. The controller may control a plurality of switches within the selection circuit and one or more switches within the resonant circuit to measure the impedance of one of the plurality of cells or perform charge balancing among the plurality of cells or among the plurality of modules.

The embodiment of FIG. 7 specifically describes a battery control apparatus which measures the impedance of one of a plurality of cells or performs charge balancing among a plurality of modules.

In the example of FIG. 7, the battery pack includes a plurality of modules, each module having five cells connected in series.

More specifically, the selection circuit 720 includes one or more switches connected to the positive electrodes of each cell and one or more switches connected to the negative electrodes of each cell. For example, the selection circuit 720 of module 1 in FIG. 7 includes six switches (W9, W10, W11, W12, W13, and W33) connected to the positive and negative electrodes of five cells. Similarly to the embodiment of FIG. 2, the selection circuit 720 according to the embodiment of FIG. 7 has the switches connected to the positive electrodes of each cell alternately connected to the first node or the second node. In other words, the switch connected to the positive electrode of the first cell, the switch connected to the positive electrode of the third cell, and the switch connected to the positive electrode of the fifth cell have their other terminals connected to the second node, and the switch connected to the positive electrode of the second cell and the switch connected to the positive electrode of the fourth cell have their other terminals connected to the first node.

Meanwhile, the switches W9, W10, W11, W12, W13, and W33 included in the selection circuit 720 may be implemented with various switching elements, and according to one embodiment, the switches may be implemented with MOSFETs. The switches W9, W10, W11, W12, W13, and W33 may be selectively turned on or off according to a control signal of a controller (not shown).

In addition, resonant circuits 730-1, 730-2, and 730-3 are arranged for each module, and in this embodiment, the resonant circuits may include an inductor connected to the first node and a capacitor connected to the second node. The battery control apparatus may further include polarity reversing switches W14, W21, and W31 located between the contact point of the first node and the inductor and the contact point of the second node and the capacitor. Here, the resonant circuits 730-1, 730-2, and 730-3 and the polarity reversing switches may perform the same role as the role of the resonant circuits and the polarity reversing switches included in the embodiment illustrated in FIG. 2. In this embodiment, the polarity reversing switch is for more efficiently transferring energy through inverting polarity of a resonant capacitor that accumulates energy. More specifically, the magnitude of the resonant current is proportional to the difference between the cell voltage and the initial voltage of the resonant capacitor. However, if charging and discharging are repeated in the same direction, the voltage of the resonant capacitor converges to the same level as the cell voltage, resulting in a continuous decrease in the magnitude of the resonant current. In the present embodiment, this problem can be solved by turning on the polarity reversing switch to reverse the polarity of the resonant capacitor.

Meanwhile, the battery control apparatus may further include one or more resonant circuit connection switch units 770-1 and 770-2 that connect the resonant circuit of the corresponding module to the resonant circuit of another adjacent module. Each resonant circuit connection switch unit may include a pair of resonant circuit connection switches (W15 and W30; W23 and W24) connected to one end and the other end of the capacitor of the resonant circuit within each module. The number of resonant circuit connection switch units may be set to (the number of modules included in the battery pack - 1).

In the embodiment of FIG. 7, for example, the resonant circuit 730-1 of module 1 and the resonant circuit 730-2 of module 2 may be connected by turning on the first resonant circuit connection switch unit 770-1. In addition, the resonant circuit 730-1 of module 1 and the resonant circuit 730-3 of module 3 may be connected by turning on the first resonant circuit connection switch unit 770-1 and the second resonant circuit connection switch unit 770-2.

The controller of the battery control apparatus may turn on the switch connected to the positive electrode of the cell to be impedance measured and the switch connected to the negative electrode, measure the current flowing through the resonant circuit and the voltage between the first node and the second node, and calculate the impedance of the target cell based on the measured current and voltage. Here, the controller may set different resonant frequencies by controlling the ON/OFF of one or more resonant circuit connection switch units. Accordingly, impedance can be measured for various resonant frequencies.

Meanwhile, the battery control apparatus according to embodiments of the present invention may further include a voltage meter (not shown) for measuring the voltage between the first node and the second node, and a current meter (not shown) for measuring the current flowing through the resonant circuit. The positions of the voltage meter and the current meter may be determined as the same positions as in the embodiment illustrated in FIG. 2.

Accordingly, the controller may turn on the switch connected to the positive electrode of the cell subject to impedance measurement and the switch connected to the negative electrode, and calculate the impedance of the cell based on the voltage obtained from the voltage meter and the current obtained from the current meter.

Furthermore, the battery control apparatus may perform charge balancing between the first module and the second module using a circuit as illustrated in FIG. 7.

More specifically, the battery control apparatus may turn on a switch connected to the positive electrode of the first cell among the series-connected cells in the first module and a switch connected to the negative electrode of the last cell among the series-connected cells, and turn on one or more resonant circuit connection switch units within the battery pack, thereby accumulating energy in capacitors within the plurality of resonant circuits.

Afterwards, the battery control apparatus may turn off the connection switches of the first module, and turn on a switch connected to the positive electrode of the first cell among the series-connected cells in the second module and a switch connected to the negative electrode of the last cell among the series-connected cells, thereby transferring energy from the first module to the second module.

Meanwhile, as illustrated in FIG. 7, when a battery pack is configured by including a plurality of modules, a single controller (not shown) may be positioned within the battery pack to control the circuitry within each module.

Here, the battery pack may include a plurality of modules, each module comprising: a plurality of series-connected cells; a selection circuit including one or more switches connected to the positive electrode of each cell and one or more switches connected to the negative electrode of each cell; and a resonant circuit including one or more inductors and one or more capacitors, one end of which is connected to the first node and the other end of which is connected to the second node.

Here, the battery pack may include a controller configured to control a plurality of switches in the selection circuit and one or more switches in the resonant circuit to measure impedance for a selected cell among the plurality of cells or perform charge balancing among the plurality of cells or charge balancing among the plurality of modules.

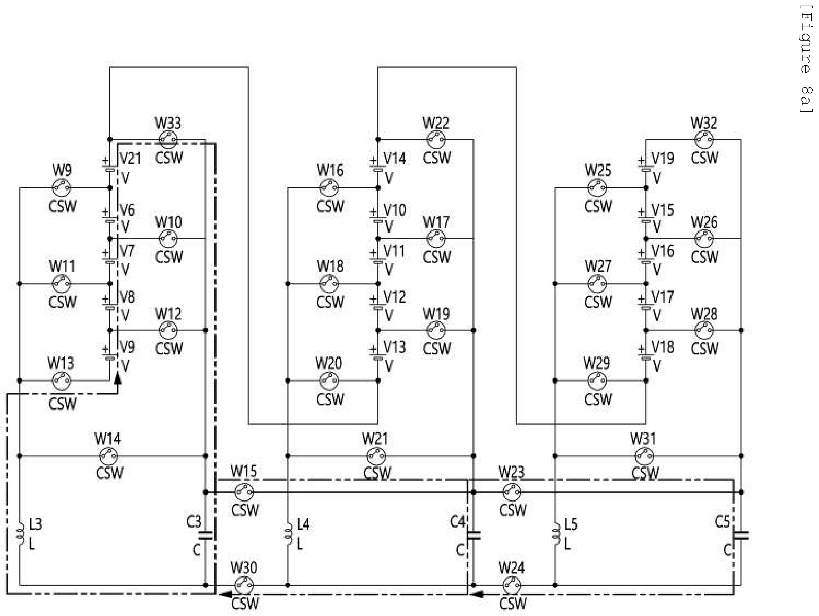

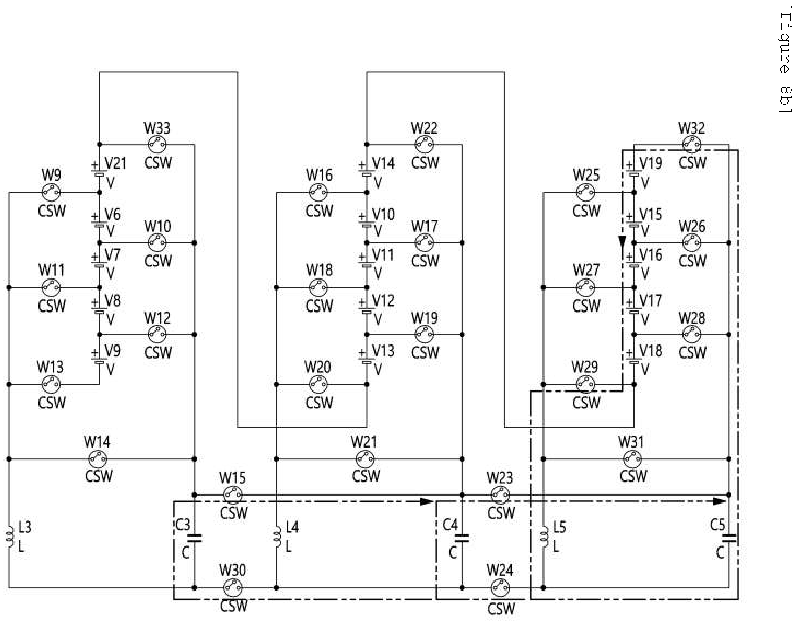

FIGS. 8a and 8b illustrate exemplary operational sequences for performing intermodule balancing using a battery control apparatus according to embodiments of the present invention.

FIGS. 8a and 8b illustrate the current flow step-by-step during a balancing operation between modules 1 and 3, when energy is transferred from module 1 to module 3.

FIG. 8a illustrates the current flow when switch 33 and switch 13 of module 1 are turned on, and a plurality of switches (W15, W30, W23, and W24) within the first resonant circuit connection switch unit and the second resonant circuit connection switch unit within the battery pack are turned on, thereby storing energy in a plurality of resonant capacitors (C3, C4, and C5) within a plurality of modules. In FIG. 8b, it is shown that switches 33 and 13 are turned off, and switches 32 and 29 of module 3 are turned on, and the energy stored in a plurality of resonant capacitors (C3, C4, C5) is transferred to module 3.

Meanwhile, as an example different from the cases illustrated in FIGS. 8a and 8b, even when energy is to be transferred from module 1 to module 2, both the first resonant circuit connection switch unit (W15, W30) and the second resonant circuit connection switch unit (W23, W24) may be turned on to store energy in three resonant capacitors (C3, C4, C5), and then the switches (W20, W22) of module 2 may be turned on to transfer the accumulated energy to module 2. Through this method, the resonant capacitance can be set as large as possible, thereby increasing the resonant current and achieving rapid balancing.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Furthermore, the computer-readable recording medium may include hardware devices specially configured to store and execute program instructions, such as ROM, RAM, flash memory, and may include, for example, various types of servers located on a network. The program instructions may include not only machine language codes, such as those created by a compiler, but also high-level language codes that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. An apparatus for controlling a battery pack including a plurality of modules, each module including a plurality of cells connected in series, the apparatus comprising:
a selection circuit comprising one or more switches connected to the positive electrode of each cell and one or more switches connected to the negative electrode of each cell;
a resonant circuit including one or more inductors and one or more capacitors, one end of the resonant circuit connected to a first node and the other end of the resonant circuit connected to a second node; and
a controller configured to control a plurality of switches in the selection circuit and one or more switches in the resonant circuit to measure impedance for a selected cell among the plurality of cells or to perform charge balancing among the plurality of cells or among the plurality of modules.

2. The apparatus of claim 1, wherein the resonant circuit includes:
a first inductor; and
a first capacitor connected in series with the first inductor.

3. The apparatus of claim 2, wherein the resonant circuit further includes:
a second inductor and an inductor connection switch which are connected in parallel with the first inductor; and
a second capacitor and a capacitor connection switch which are connected in parallel with the first capacitor.

4. The apparatus of claim 3, wherein a resonant frequency provided by the resonant circuit varies depending on ON/OFF of the inductor connection switch and the capacitor connection switch.

5. The apparatus of claim 1, further comprising:
a voltage meter measuring a voltage between the first node and the second node; and
a current meter measuring a current flowing through the resonant circuit.

6. The apparatus of claim 5, wherein the controller is further configured to:
turn on a switch connected to the positive electrode of a cell to be impedance measured and a switch connected to the negative electrode of the cell; and
calculate the impedance of the cell based on a voltage obtained from the voltage meter and a current obtained from the current meter.

7. The apparatus of claim 1, further comprising:
a polarity reversing switch having one end connected to the first node and the other end connected to the second node.

8. The apparatus of claim 7, wherein the controller is further configured to:
turn on the positive connection switch and the negative connection switch of the first cell, thereby accumulating energy in the capacitor within the resonant circuit; and
subsequently, turn off the positive connection switch and the negative connection switch of the first cell and turn on the positive connection switch and the negative connection switch of the second cell, so that energy from the first cell is transferred to the second cell.

9. The apparatus of claim 8, wherein the controller is further configured to:
if the first cell and the second cell are, in terms of the serial connection structure of the cells, one is an odd cell and the other is an even cell,
before controlling turning on of the positive connection switch and the negative connection switch of the second cell, turn on the polarity reversing switch to reverse the polarity of the capacitor within the resonant circuit; and
subsequently, turn on the positive connection switch and the negative connection switch of the second cell, thereby transferring energy stored in the capacitor to the second cell.

10. The apparatus of claim 8, wherein the controller is further configured to:
if the first cell and the second cell are, in terms of the serial connection structure of the cells, both are odd cells or both are even cells,
after transferring energy stored in the capacitor to the second cell, turn on the polarity reversing switch to reverse the polarity of the capacitor within the resonant circuit.

11. The apparatus of claim 3, wherein the controller controls the inductor connection switch and the capacitor connection switch to be turned off when performing cell-to-cell charge balancing from a first cell to a second cell.

12. The apparatus of claim 1, wherein the resonant circuit includes:
an inductor connected to the first node; and
a capacitor connected to the second node, and
wherein the resonant circuit is arranged in each module.

13. The apparatus of claim 12, further comprising:
one or more resonant circuit connection switch units connecting resonant circuits located within each module,
wherein each resonant circuit connection switch unit includes a pair of resonant circuit connection switches connected to one end and the other end of a capacitor of a resonant circuit within each module.

14. The apparatus of claim 13, wherein the controller is configured to perform charge balancing between a first module and a second module by:
turning on a switch connected to the positive electrode of a first cell among the series-connected cells in the first module and a switch connected to the negative electrode of a last cell among the series-connected cells and turning on the one or more resonant circuit connection switch units within the battery pack, thereby accumulating energy in capacitors within a plurality of resonant circuits; and
subsequently, turning off connection switches of the first module and turning on a switch connected to the positive electrode of a first cell among the series-connected cells in the second module and a switch connected to the negative electrode of a last cell among the series-connected cells in the second module.

15. The apparatus of claim 13, wherein the controller is configured to:
turn on a switch connected to the positive electrode and a switch connected to the negative electrode of a cell to be impedance measured;
measure a current flowing through the resonant circuit and a voltage between the first node and the second node; and
calculate the impedance of the target cell based on the measured current and voltage.

16. The apparatus of claim 15, wherein a resonant frequency of the resonant circuit varies depending on ON/OFF state of the one or more resonant circuit connection switch units.

17. A battery pack comprising a plurality of modules, each module including:
a plurality of cells connected in series;
a selection circuit including one or more switches connected to the positive electrode of each cell and one or more switches connected to the negative electrode of each cell; and
a resonant circuit including one or more inductors and one or more capacitors, one end of the resonant circuit connected to a first node and the other end of the resonant circuit connected to a second node,
wherein the battery pack includes:
a controller configured to control a plurality of switches in the selection circuit and one or more switches in the resonant circuit to measure impedance for a selected cell among the plurality of cells or to perform charge balancing among the plurality of cells or charge balancing among the plurality of modules.
